(19)

Europäisches
Patentamt

European
Patent Office

Office européen
des brevets

(11)  **EP 2 753 099 A1**

(12)  # EUROPEAN PATENT APPLICATION
published in accordance with Art. 153(4) EPC

(43) Date of publication:
**09.07.2014 Bulletin 2014/28**

(21) Application number: **12828211.8**

(22) Date of filing: **29.08.2012**

(51) Int Cl.:
*H04R 19/04* (2006.01)    *H01L 29/84* (2006.01)
*H04R 31/00* (2006.01)

(86) International application number:
**PCT/JP2012/071800**

(87) International publication number:
**WO 2013/031811 (07.03.2013 Gazette 2013/10)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:   **30.08.2011   JP 2011186833**

(71) Applicant: **Omron Corporation
Kyoto-shi, Kyoto 600-8530 (JP)**

(72) Inventors:
  • **NAKAGAWA Yusuke
    Kyoto-shi
    Kyoto 600-8530 (JP)**
  • **TATARA Yoshitaka
    Kyoto-shi
    Kyoto 600-8530 (JP)**

  • **IIDA Nobuyuki
    Kyoto-shi
    Kyoto 600-8530 (JP)**
  • **ISHIMOTO Koichi
    Kyoto-shi
    Kyoto 600-8530 (JP)**
  • **HAMAGUCHI Tsuyoshi
    Kyoto-shi
    Kyoto 600-8530 (JP)**
  • **KANO Hajime
    Kyoto-shi
    Kyoto 600-8530 (JP)**

(74) Representative: **Isarpatent
Patent- und Rechtsanwälte
Friedrichstrasse 31
80801 München (DE)**

(54)  ## ACOUSTIC SENSOR AND METHOD FOR MANUFACTURING SAME

(57)    A cavity 44 is provided in a substrate 42 so as to penetrate from a front surface to a back surface of the substrate. A thin-film diaphragm 43 for sensing acoustic vibrations above the substrate 42 is provided over the cavity 44. At least one wall surface of the cavity 44 is configured of a first inclined surface 47a between the front surface of the substrate 42 and a middle portion in the thickness direction, the first inclined surface 47a gradually widening toward the outside of the substrate 42 as the first inclined surface 47a goes from the front surface of the substrate 42 toward the middle portion, and a second inclined surface 47b between the middle portion and the back surface of the substrate 42, the second inclined surface 47b gradually narrowing toward the inside of the substrate 42 as the second inclined surface 47b goes from the middle portion toward the back surface of the substrate 42. The width of the back surface opening of the cavity 44 is smaller than the width of the front surface opening of the cavity 44.

Fig. 10

## Description

TECHNICAL FIELD

The present invention relates to an acoustic sensor and a method for manufacturing the acoustic sensor, and in particular, to an acoustic sensor used as a highly sensitive microphone and a method for manufacturing the microphone.

BACKGROUND ART

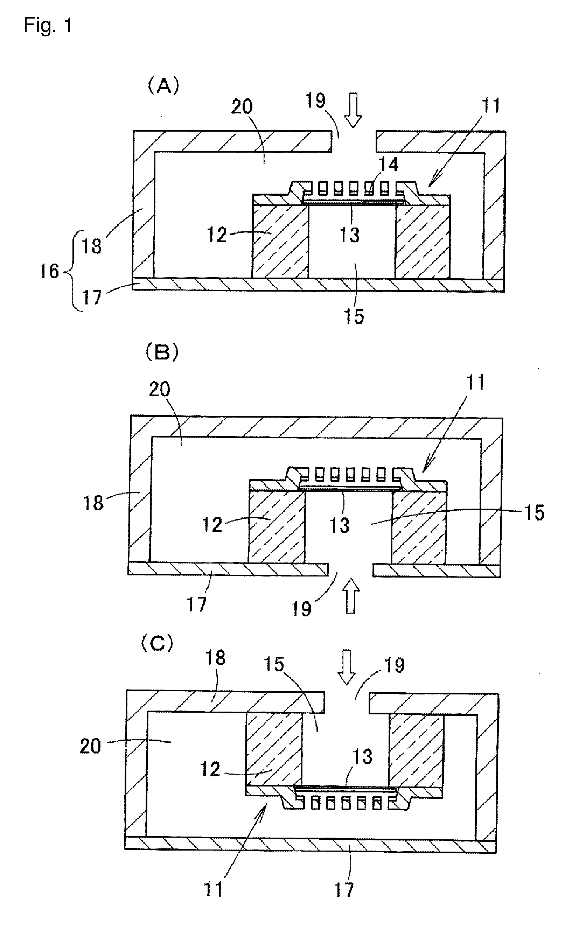

Fig. 1 (A), Fig. 1 (B), and Fig. 1 (C) are sectional views of a microphone module that stores a conventional acoustic sensor in a casing. The acoustic sensor 11 has a thin-film diaphragm 13 (movable electrode) and a fixed electrode 14 over a front surface of a substrate 12, and a cavity 15 is formed in the substrate 12 adjacent to a back surface of the diaphragm 13. The acoustic sensor 11 is a capacitive sensor for detecting acoustic vibrations on the basis of a change in capacitance between the diaphragm 13 and the fixed electrode 14. The casing 16 includes a base 17 and a cover 18 that covers over the base 17.

As shown in Fig. 1 (A), in the acoustic sensor 11, the back surface of the substrate 12 is mounted on an upper surface of the base 17, and the cover 18 has an acoustic introduction port 19. In such mounting mode, space 20 in the casing 16 serves as an acoustic front chamber, and the cavity 15 of the acoustic sensor 11 serves as an acoustic back chamber.

The front chamber is space in front of the diaphragm in the entry direction of acoustic vibrations (represented by a hollow arrow). The back chamber is space behind the diaphragm in the entry direction of acoustic vibrations, from which acoustic vibrations vibrating the diaphragm escapes. The back chamber functions as an "air spring" in the microphone module, and as the volume of the back chamber increases, the "air spring" becomes softer, increasing the sensitivity of the acoustic sensor 11.

Thus, in some microphone modules, as shown in Fig. 1 (B), the base 17 has the acoustic introduction port 19, and the acoustic sensor 11 is mounted on the upper surface of the base 17 such that the cavity 15 is in communication with the acoustic introduction port 19. Alternatively, as shown in Fig. 1 (C), the cover 18 has the acoustic introduction port 19, and the acoustic sensor 11 is mounted on the lower surface of the cover 18 such that the cavity 15 is in communication with the acoustic introduction port 19.

In the microphone modules shown in Fig. 1 (B) and Fig. 1 (C), since acoustic vibrations entered from the acoustic introduction port 19 approaches the diaphragm 13 from the cavity 15, the space 20 in the casing 16 serves as the back chamber. With such configuration, as compared to the configuration in Fig. 1 (A) in which the cavity 15 serves as the back chamber, the volume of the back chamber (space 20) can be increased, increasing the sensitivity of the acoustic sensor 11. For this reason, the microphone modules with a structure as shown in Fig. 1 (B) and Fig. 1 (C) have recently received attention.

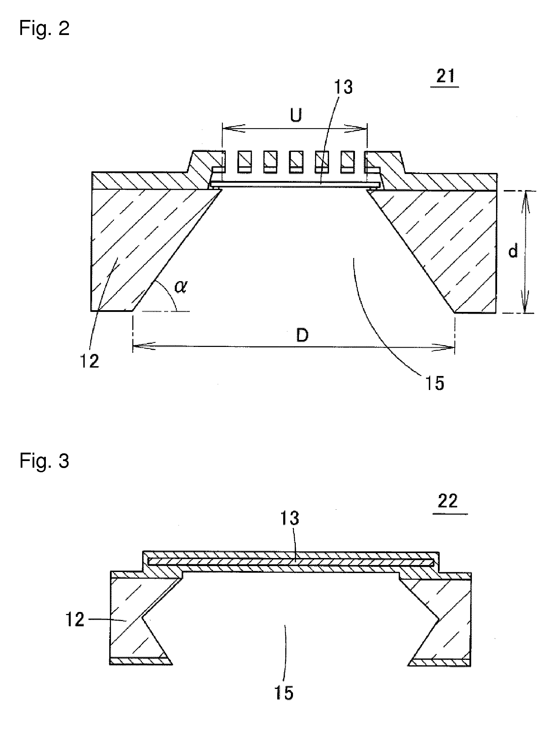

In manufacturing the acoustic sensor, an inexpensive (100) plane Si substrate is generally used as the substrate 12. When the substrate 12 is wet-etched from the back surface to form the cavity 15, as in an acoustic sensor 21 shown in Fig. 2, an opening in the back surface of the substrate 12 (hereinafter referred to as back surface opening) is larger than an opening in the front surface of the substrate 12 (hereinafter referred to as front surface opening) to define a tapered cavity 15. This is due to that wet etching starts from the back surface of the substrate 12, the etching rate is small in the direction perpendicular to a (111) plane as the most close-packed plane, and the (111) plane forms a wall surface of the cavity 15.

As shown in Fig. 2, given that in the (100) plane Si substrate, an angle $\alpha$ that the (111) plane forms with the back surface of the substrate 12 is 54 degrees, a thickness of the substrate 12 is d, a width of the front surface opening of the cavity 15 is U, and a width of the back surface opening of the cavity 15 is D, the width D of the back surface opening is obtained by a following equation:

$$D = U + 2 \times d/\tan\alpha \approx U + 1.5 \times d$$

Thus, when the cavity 15 is formed such that the width U of the front surface opening is substantially equal to the width of the diaphragm 13, the width D of the back surface opening of the cavity 15 is rather large.

Fig. 3 is a sectional view of an acoustic sensor 22 described in Patent Document 1. The cavity 15 of the acoustic sensor 22 is barrel-shaped. That is, in the cavity 15, the width of a cross section parallel to the front surface of the substrate 12 gradually increases toward the back surface of the substrate 12 from the front surface of the substrate 12 to a middle portion in the thickness direction, and gradually decreases toward the back surface of the substrate 12 from the middle portion in the thickness direction of the substrate 12 to the back surface. The width of the back surface opening of the cavity 15 in the acoustic sensor 22 disclosed in Patent Document 1 is smaller than that of the tapered cavity as shown in Fig. 2. However, in the acoustic sensor 22 in Patent Document 1, a site (section), where the width of the cross section parallel to the front surface of the substrate stops increasing and starts to decrease, is closer to the back surface than to the center of the substrate 12 in the thickness direction so that the width of the back surface opening in the cavity 15 is larger than that of the front surface opening.

Fig. 4(A) is a sectional view of a MEMS device 23 described in Patent Document 2. Similarly, in the MEMS device 23, the width of the cross section parallel to the front surface of the substrate 12 gradually increases toward the back surface of the substrate 12 from the front surface of the substrate 12 to a middle portion in the thickness direction, and gradually decreases toward the back surface of the substrate 12 from the middle portion of the substrate 12 in the thickness direction to the back surface to define the cavity 15.

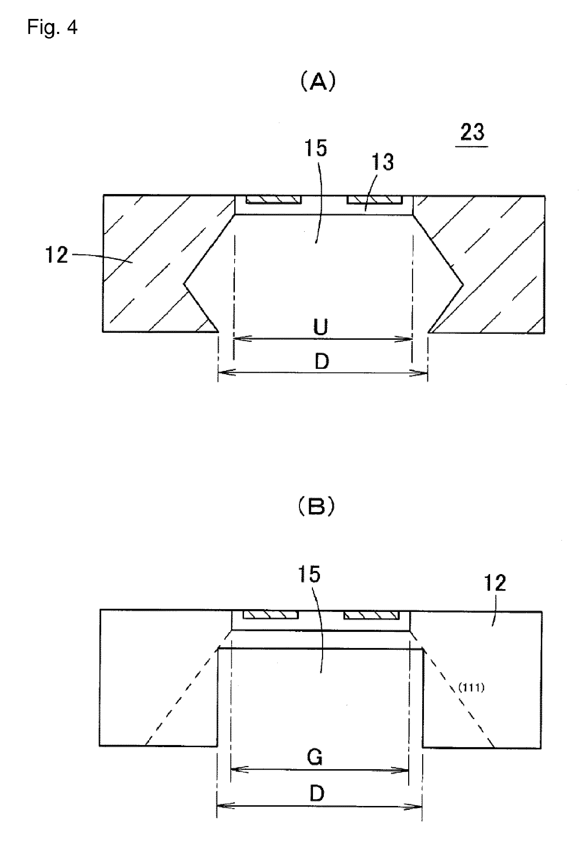

Fig. 4(B) shows a method for forming the cavity 15 in the MEMS device 23. That is, when the cavity 15 is formed in the substrate 12, by dry-etching the substrate 12 from the back surface, as shown in Fig. 4(B), the cavity 15 having a rectangular cross section, with an opening width D larger than a width G of the diaphragm 13, is formed in the substrate 12. The cavity 15 at this time has a depth such that the deepest corners contact with (111) planes passing respective ends of the diaphragm 13. After that, by widening the cavity 15 by wet-etching to expose each (111) plane, the cavity 15 has a barrel-shaped cross section. Through such manufacturing process, the MEMS device 23 in Patent Document 2 has the width D of the back surface opening of the cavity 15, which is larger than the width U of the front surface opening of the cavity 15.

In all of the acoustic sensor 21 in Fig. 2, the acoustic sensor 22 in Fig. 3, and the MEMS device 23 in Fig. 4, the width of the back surface opening of the cavity 15 is larger than the width of the front surface opening. Thus, when the acoustic sensors 21, 22, or the MEMS device 23 is mounted on the cover 18 or the base 17 at the acoustic introduction port 19 to communicate the acoustic introduction port 19 with the cavity 15, a new problem occurs as described below.

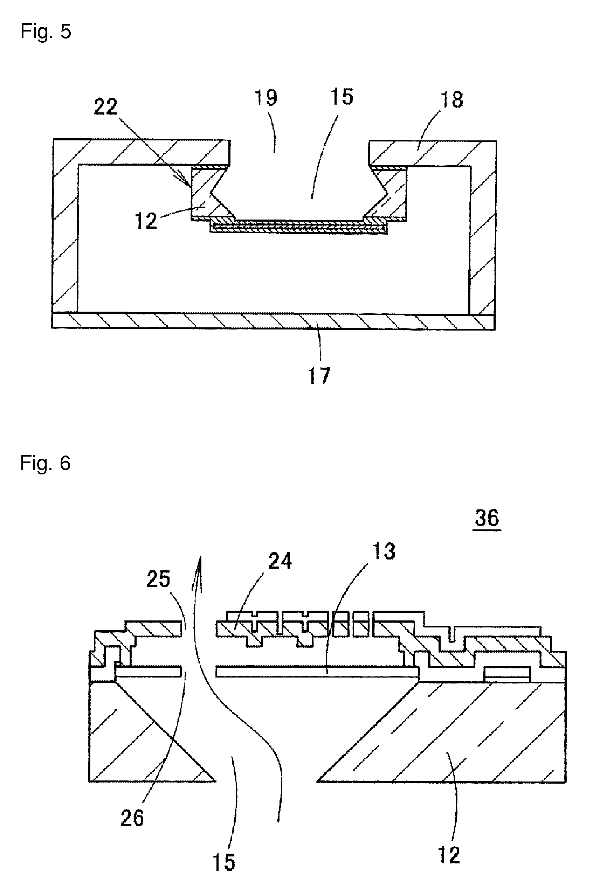

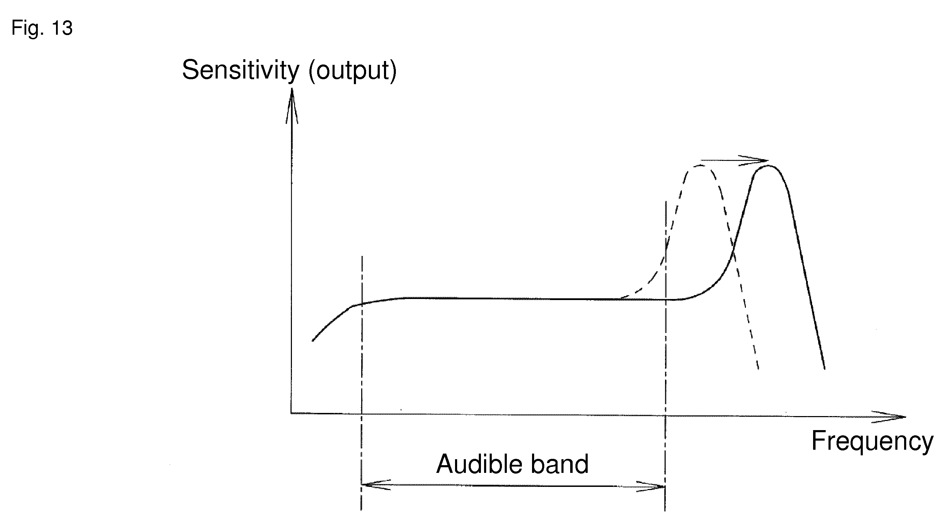

Fig. 5 shows a case where the acoustic sensor 22 in Fig. 3 is mounted on the lower surface of the cover 18 at the acoustic introduction port 19. In the microphone module shown in Fig. 5, the cavity 15 of the acoustic sensor 22 serves as the front chamber, and acoustic vibrations approaches diaphragm 13 from the back surface. Thus, when the volume of the cavity 15 is large, it affects acoustic characteristics in a high frequency region of the acoustic sensor 22, and high-frequency characteristics are susceptible to resonance (represented by a broken line in Fig. 13).

Since the back surface opening of the cavity 15 facing the acoustic introduction port 19 is wide, when the acoustic introduction port 19 is located on the upper surface of the microphone module, or is opposed to an opening of a device into which the microphone module is integrated, dirt and dust enter through the cavity 15 to easily adhere to the diaphragm 13. When dirt and dust adhere to the diaphragm 13, vibration characteristics of the diaphragm 13 change, affecting the acoustic sensor 22.

Such problem also occurs in the MEMS device 23 as shown in Fig. 4. The problem becomes more prominent in the acoustic sensor 22 having the tapered cavity as shown in Fig. 2.

On the contrary, an acoustic sensor 36 disclosed in Patent Document 3 has an inverted tapered cavity 15 as shown in Fig. 6. That is, the width of the cross section parallel to the front surface of the substrate 12 in the cavity 15 gradually decreases from the front surface toward the back surface of the substrate. In this form of cavity 15, since the width of the back surface opening as well as its volume are small, the above-mentioned problem does not occur.

However, in the acoustic sensor 36 described in Patent Document 3, an etching liquid is introduced to the front surface of the substrate 12 through an etching hole 25 in a back plate 24 and an etching hole 26 in the diaphragm 13, and the substrate 12 is etched from the front surface toward the back surface of the substrate 12, thereby forming the cavity 15.

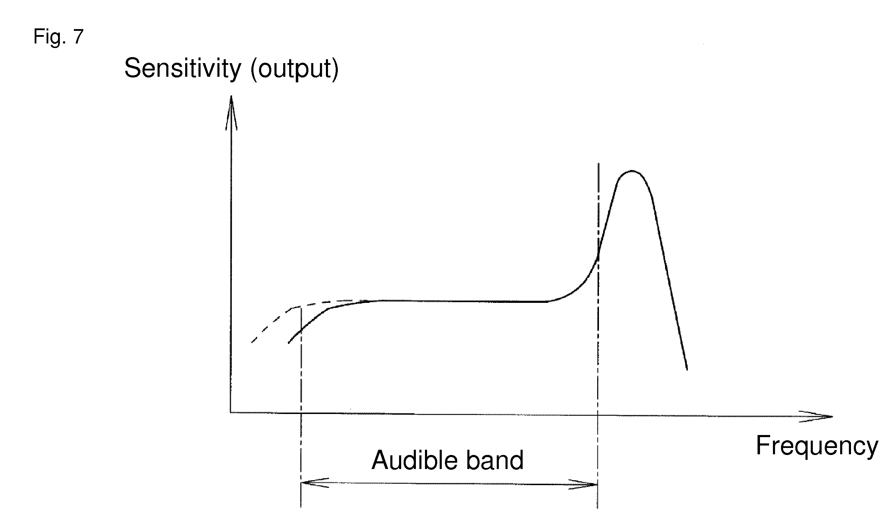

When the acoustic sensor 36 in Patent Document 3 is mounted in the casing to block the acoustic introduction port, the cavity 15 (front chamber) communicates with a space in the casing (back chamber) through the etching holes 25, 26 with a small acoustic resistance. For this reason, as represented by an arrow in Fig. 6, acoustic vibrations exerted into the cavity 15 easily pass through the etching holes 25, 26 and leak into the space in the casing. Leakage of acoustic vibrations may result in that acoustic vibrations are hard to transmit to the diaphragm 13, leading to a decrease in sensitivity. Specifically, as represented by a solid line in Fig. 7, the sensitivity greatly decreases in a low-frequency region in an audible band (20 Hz to 20 kHz). A curve represented by a broken line in Fig. 7 shows the sensitivity in the case where the etching holes are blocked.

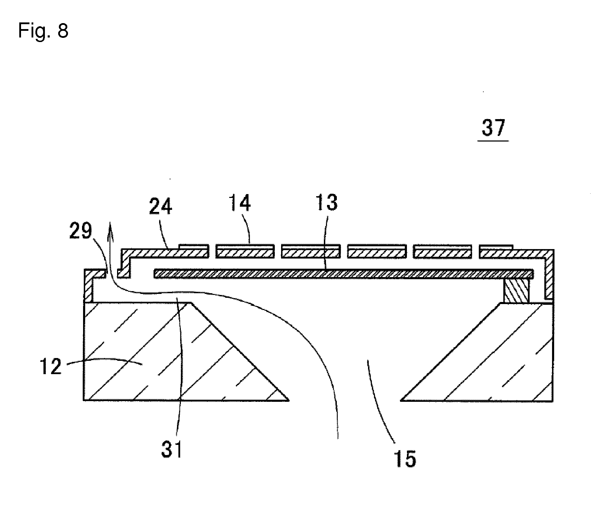

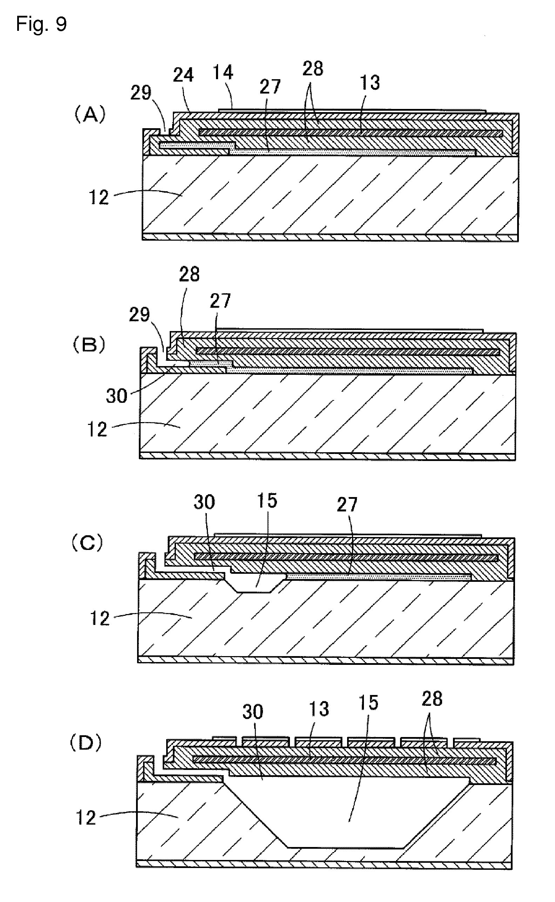

Patent Document 4 discloses an acoustic sensor 37 having the inverted tapered cavity 15 as shown in Fig. 8. The acoustic sensor 37 is manufactured through steps shown in Fig. 9(A) to Fig. 9(D). That is, as shown in Fig. 9(A), a sacrifice layer 27 is formed in a cavity formation region of the front surface of the substrate 12, and a part of the sacrifice layer 27 extends and is floated from the substrate 12 at one end of the substrate 12. A protection film 28 is formed on the sacrifice layer 27, and the diaphragm 13 is formed on the protection film 28. Further, the protection film 28 is formed on the diaphragm 13, the back plate 24 is formed thereon, and the fixed electrode 14 is provided on the upper surface of the back plate 24. An etching hole 29 is formed in the back plate 24 above the extended part of the sacrifice layer 27.

The protection film 28 is etched directly below the etching hole 29 to form a hole in the protection film 28, thereby exposing the extended part of the sacrifice layer 27. Next, as shown in Fig. 9(B), an etching liquid is introduced through the etching hole 29 to etch the sacrifice layer 27. Since the etching liquid has an etching characteristic for the sacrifice layer 27 and the substrate 12, as shown in Fig. 9(C), when the etching liquid enters into a passage 30 formed by etching the sacrifice layer 27 and contacts with the substrate 12, the substrate 12 is etched from the front surface. As a result, as shown in Fig. 9(D), the inverted-tapered cavity 15 is gradually deepened in the substrate 12. When etching reaches the back surface of the substrate 12, etching of the substrate 12 is stopped, and the protection film 28 is removed by etching to produce the acoustic sensor 37 as shown in Fig. 8.

Unless a vent hole of the acoustic sensor is formed in a very small space, the acoustic sensor cannot acquire a high acoustic resistance, and acoustic vibrations leak through the vent hole. Since the extended part of the sacrifice layer 27 becomes the passage 30 for the etching liquid, the acoustic sensor 37 requires a large cross-sectional area. When the passage 30 for the etching liquid is narrow, circulation of the etching liquid is hampered, decreasing the etching rate of the substrate 12, in turn, the productivity of the acoustic sensor. However, according to the method for manufacturing the acoustic sensor in Patent Document 4, as shown in Figs. 9, the extended part of the sacrifice layer 27 passes through a formation part of a vent hole 31. Thus, a thickness of the vent hole 31 becomes larger than a thickness of the extended part of the sacrifice layer 27 and therefore, the vent hole 31 cannot be narrowed. Similarly, unless the etching hole 29 in the back plate 24 is large, the circulation of the etching liquid is hampered, decreasing the etching rate of the substrate 12, in turn, the production yield of the acoustic sensor.

For this reason, in the acoustic sensor in Patent Document 4, the acoustic resistance is small from the vent hole 31 to the etching hole 29. Thus, like the acoustic sensor in Patent Document 3, acoustic vibrations entering into the cavity 15, as represented by an arrow in Fig. 8, easily pass through the vent hole 31 and the etching hole 29, and leaks into the space in the casing. This lowers the sensitivity of the acoustic sensor, especially in the low-frequency region.

In consideration of the above-mentioned circumstances, it is desired that the cavity of the acoustic sensor can be manufactured by processing only from the back surface of the substrate.

Patent Document 1: Japanese Patent No. 4273438
Patent Document 2: Specification of U.S. Patent No. 7514287
Patent Document 3: Japanese Patent No. 4539450
Patent Document 4: Japanese Unexamined Patent Publication No. 2007-295487

SUMMARY OF THE INVENTION

PROBLEMS TO BE SOLVED BY THE INVENTION

The present invention is made in consideration of the above-mentioned technical problem, and its object is to provide an acoustic sensor in which a cavity is formed in a substrate by etching from a back surface of the substrate, and the cavity has an opening in the back surface of the substrate, which is smaller than an opening in a front surface of the substrate, and a method for manufacturing the acoustic sensor.

MEANS FOR SOLVING THE PROBLEM

An acoustic sensor according to the present invention includes

a substrate having a cavity penetrating from a front surface to a back surface;
a thin-film diaphragm arranged adjacent to the front surface of the substrate to cover the cavity; and
a conversion unit configured to convert acoustic vibrations into an electrical signal on the basis of displacement of the diaphragm, and the cavity has a plurality of wall surfaces, at least one wall surface of the plurality of wall surfaces is configured of a first inclined surface and a second inclined surface, wherein
the first inclined surface is between the front surface of the substrate and a middle portion in a thickness direction of the substrate, the first inclined surface gradually widening toward the outside of the substrate as the first inclined surface goes from the front surface of the substrate toward the middle portion, and
the second inclined surface is between the middle portion and the back surface of the substrate, the second inclined surface narrowing toward the inside of the substrate as the second inclined surface goes from the middle portion to the back surface of the substrate, and
in a cross section perpendicular to the wall surface configured of the first inclined surface and the second inclined surface, an opening width of the cavity in the back surface of the substrate is smaller than an opening width of the cavity in the front surface of the substrate.

In the acoustic sensor of the present invention, since the opening width of the cavity on the side of the back surface of the substrate is smaller than the opening width on the side of the front surface of the substrate, even when the back surface of the acoustic sensor is mounted in the casing at an acoustic introduction port formed in the casing, dirt and dust are hard to enter into the cavity. Thus, dirt and dust entered into the cavity can be prevented from adhering to the diaphragm, changing or degrading characteristics of the acoustic sensor. Further, since the area of the back surface of the substrate can be increased by a decrease in the back surface opening of the cavity, fixing strength and stability in mounting the acoustic sensor in the casing can be improved.

In the acoustic sensor of the present invention, since the volume of the cavity can be reduced by making the back surface opening width of the cavity smaller than the front surface opening width, high frequency characteristics of the acoustic sensor can be improved.

Moreover, since at least one wall surface of the wall surfaces of the cavity is configured of the first inclined surface that gradually widening toward the outside of the substrate as the first inclined surface goes from front surface of the substrate toward a middle portion, and the second inclined surface between the middle portion and the back surface of the substrate, the second inclined surface narrowing toward the inside of the substrate as the second inclined surface goes from the middle portion to the back surface of the substrate, as described above, the cavity can be formed by etching from only the back surface of the substrate, and the sensor structure on the front surface of the substrate does not need to have an etching hole. For this reason, acoustic vibrations entered into the cavity are not applied to the diaphragm and leak through the etching hole, resulting in a large acoustic resistance of the acoustic sensor, thereby preventing lowering of the sensitivity in a low frequency region.

In the acoustic sensor of the present invention, at least one pair of wall surfaces facing each other of the wall surfaces, each may be configured of the first inclined surface and the second inclined surface. The opposed wall surfaces may have different heights from the back surface of the substrate to the boundary between the first inclined surface and the second inclined surface.

In the acoustic sensor of the present invention, given that a thickness of the substrate is d, an inclination angle of the first and second inclined surfaces is $\alpha$, and in a cross section perpendicular to the wall surface configured of the first and second inclined surfaces, it is desired that an opening width of the cavity in the front surface of the substrate and an opening width of the cavity in the back surface of the substrate are U and D, respectively, a following condition:

$$D > U - 2 \times d/\tan\alpha$$

is satisfied. By satisfying this condition, the first inclined surface and the second inclined surface can be formed.

Describing the acoustic sensor of the present invention in terms of the cross-sectional area of the cavity, in a region near the opening in the front surface of the substrate, the area of the cross section parallel to the substrate front surface gradually increases from the front surface toward the back surface of the substrate, and in a region near the opening in the back surface of the substrate, the area of the cross section parallel to the substrate front surface gradually decreases from the front surface toward the back surface of the substrate.

More specifically, in a certain case, the area of the cross section parallel to the front surface of the substrate in the cavity gradually increases from the front surface toward the back surface of the substrate and then, stops increasing and decreases from the middle of the front surface and the back surface of the substrate. For example, it is the case where the wall surfaces have the same height of the boundary between the first inclined surface and the second inclined surface.

In another case, the area of the cross section parallel to the front surface of the substrate in the cavity gradually increases from the front surface toward the back surface of the substrate with a relatively large increase rate, and gradually decreases with a relatively large decrease rate when an increase or decrease in the cross-sectional area becomes small. For example, it is the case where the wall surfaces have different heights of the boundary between the first inclined surface and the second inclined surface.

In these specific mode, when a thickness of the region, where the area of the cross section parallel to the front surface of the substrate in the cavity gradually increases from the front surface toward the back surface of the substrate, is smaller than a thickness of the region where the area of the cross section parallel to the front surface of the substrate in the cavity gradually decreases from the front surface toward the back surface of the substrate, the opening area of the cavity in the back surface of the substrate can be made smaller than the opening area of the cavity in the front surface of the substrate.

Examples of the means or units for converting acoustic vibrations into the electrical signal include a capacitive type and a piezoresistance type. For example, the capacitive conversion unit can be formed of a fixed electrode made of a conductive material and arranged adjacent to the front surface of the substrate so as to be parallel to the diaphragm. When the diaphragm is deformed by acoustic vibrations, such conversion unit outputs an electrical signal as a change in capacitance between the diaphragm and the fixed electrode.

A method for manufacturing the acoustic sensor according to the present invention includes steps of:

preparing a sacrifice layer on the front surface of the substrate;

preparing the thin-film diaphragm above the sacrifice layer;

preparing the conversion unit configured to convert acoustic vibrations into an electrical signal on the basis of displacement of the diaphragm;

forming a through hole on the substrate, the through hole having a smaller opening width in a direction parallel to the back surface of the substrate than a width of the sacrifice layer, by

dry etching the substrate from the back surface of the substrate to cause the hole to penetrate the substrate from the back surface to the front surface along the thickness direction of the substrate; and

forming the cavity in the substrate by anisotropically etching the substrate from the front surface of the substrate and removing the sacrifice layer through etching and anisotropically etching the substrate from an inner wall surface of the through hole by introducing an etching liquid into the through hole.

According to the method for manufacturing the acoustic sensor of the present invention, since the first inclined surface can be formed by anisotropically etching the substrate from the front surface of the substrate while etching and removing the sacrifice layer with the etching liquid introduced into the through hole, and the second inclined surface can be formed by anisotropically etching the substrate from the inner wall surface of the sacrifice layer, the cavity consisting of the first inclined surface and the second inclined surface can be formed by etching from the back surface only.

Moreover, according to the manufacturing method, the sacrifice layer is formed in a region corresponding to the front surface opening of the cavity, and the opening of the through hole in the back surface of the substrate is formed in a region corresponding to the back surface opening of the cavity. Since the opening width or the opening area of the cavity in the front surface of the substrate is determined depending on the width or the area of the sacrifice layer, and the opening width or the opening area of the cavity in the back surface of the substrate is determined depending on the opening width or the opening area of the through hole in the back surface of the substrate, size of the front surface opening and the back surface opening of the cavity can be easily controlled.

According to the method for manufacturing the acoustic sensor of the present invention, in the step of forming the through hole, the center of the through hole may be displaced from the horizontal center of the sacrifice layer in a horizontal direction to form the through hole. By displacing the position of the through hole from the center of the sacrifice layer in this manner, the height of the boundary between the first inclined surface and the second inclined surface in a pair of opposed wall surfaces located in the displaced direction of the through hole can be made different from each other.

Even when the position of the through hole is displaced, in the case where at least a part of the through hole overlaps the sacrifice layer when viewed in the direction perpendicular to the front surface of the substrate, the sacrifice layer can be removed by etching using an etching liquid introduced into the through hole.

The embodiments of the present invention have features obtained by appropriately combining the above-mentioned constituents and therefore, the present invention can be varied according to any combinations of the constituents.

BRIEF DESCRIPTION OF THE DRAWINGS

Fig. 1 (A) is a sectional view of a microphone module in which a conventional acoustic sensor having a cavity in the sensor as a back chamber is mounted in a casing, and Fig. 1 (B) and Fig. 1 (C) each are sectional views of a microphone module in which the conventional acoustic sensor having a cavity in the sensor as a front chamber is mounted in the casing
Fig. 2 is a sectional view of a conventional acoustic sensor having a tapered cavity.
Fig. 3 is a sectional view of an acoustic sensor described in Patent Document 1.
Fig. 4(A) is a sectional view of an acoustic sensor described in Patent Document 2, and Fig. 4(B) is a view showing a method for manufacturing the acoustic sensor in Patent Document 2
Fig. 5 is a sectional view showing the state where the acoustic sensor in Patent Document 1 in Fig. 3, which includes a cavity in the sensor as a front chamber, is mounted in a casing.
Fig. 6 is a sectional view of an acoustic sensor described in Patent Document 3.
Fig. 7 is a graph of a frequency-sensitivity characteristic of the acoustic sensor in Patent Document 3 in Fig. 6.
Fig. 8 is a sectional view of an acoustic sensor described in Patent Document 4.
Fig. 9(A) to Fig. 9(D) are sectional views showing a method for manufacturing the acoustic sensor in Patent Document 4 in Fig. 8.

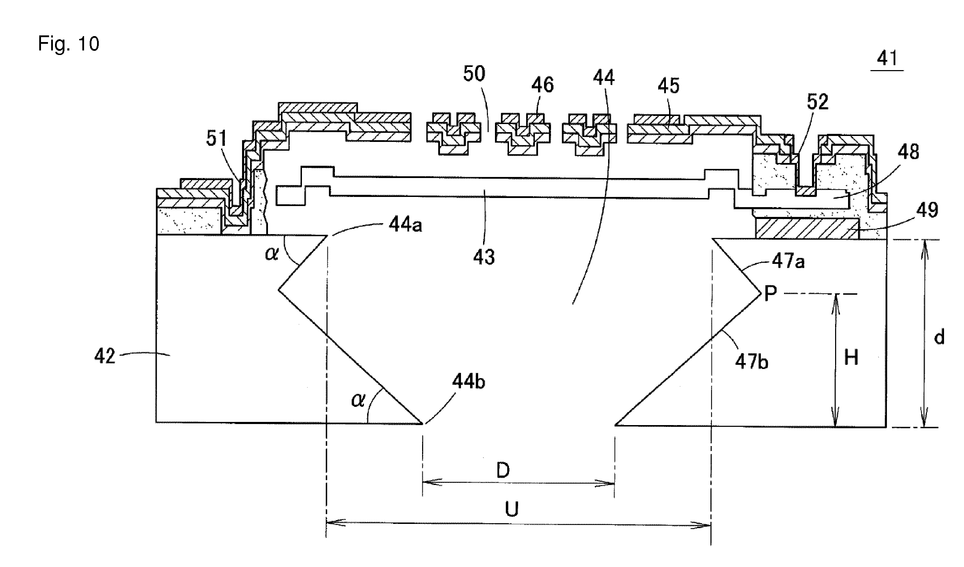

Fig. 10 is a sectional view of an acoustic sensor in accordance with a first embodiment of the present invention.

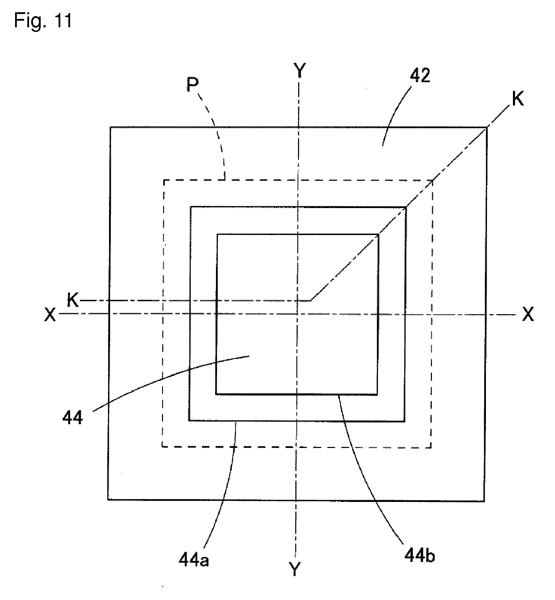

Fig. 11 is a plan view of a substrate of the acoustic sensor in accordance with a first embodiment in Fig. 10.

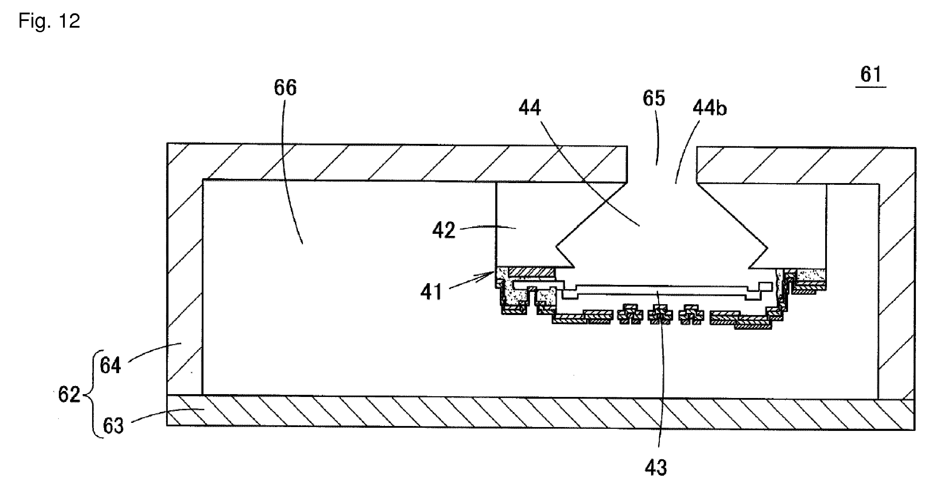

Fig. 12 is a sectional view showing the state where the acoustic sensor in First Embodiment in Fig. 10, which includes a cavity in the sensor as a front chamber, is mounted in a casing.
Fig. 13 is a graph showing a frequency-sensitivity characteristic of the acoustic sensor in accordance with a first embodiment of the present invention.

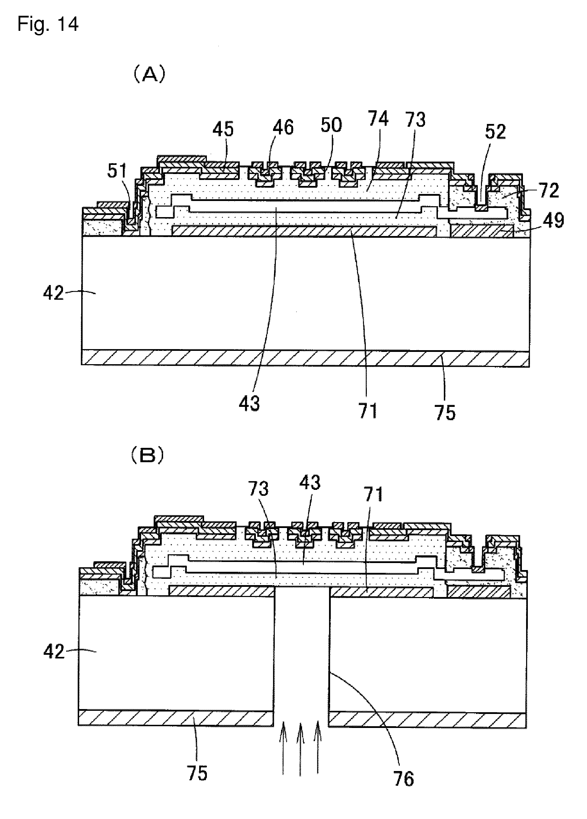

Fig. 14(A) and Fig. 14(B) are sectional views showing a method for manufacturing the acoustic sensor in Fig. 10.

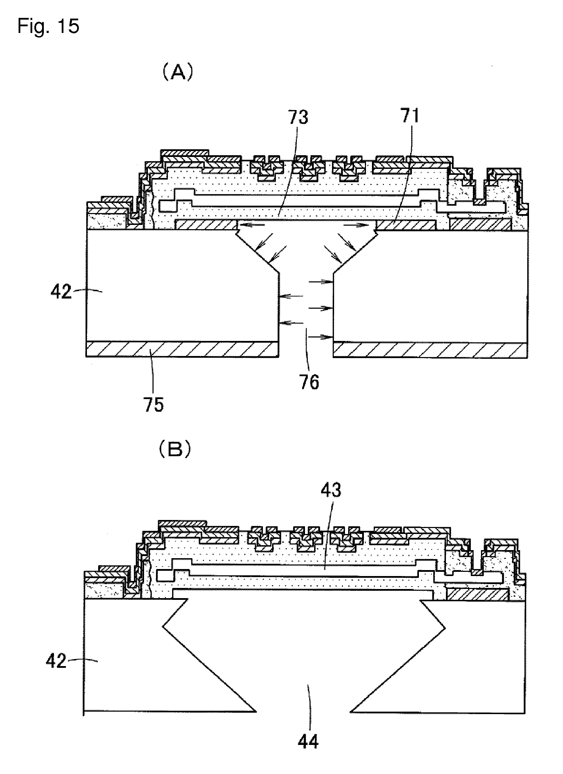

Fig. 15(A) and Fig. 15(B) are sectional views showing steps subsequent to the step in Fig. 14(B) in the method for manufacturing the acoustic sensor in Fig. 10.

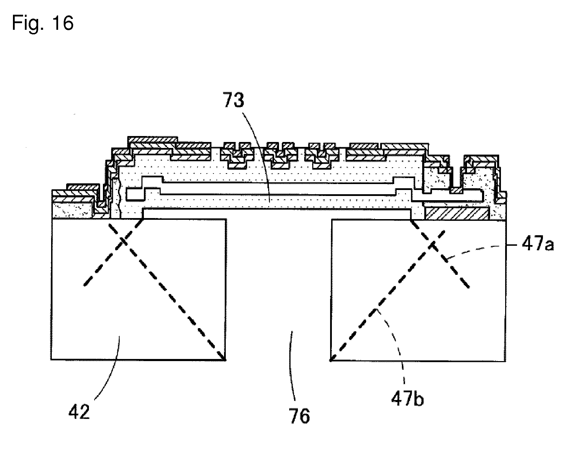

Fig. 16 is a schematic view showing the state where a barrel-shaped cavity is formed in a substrate by anisotropic etching.

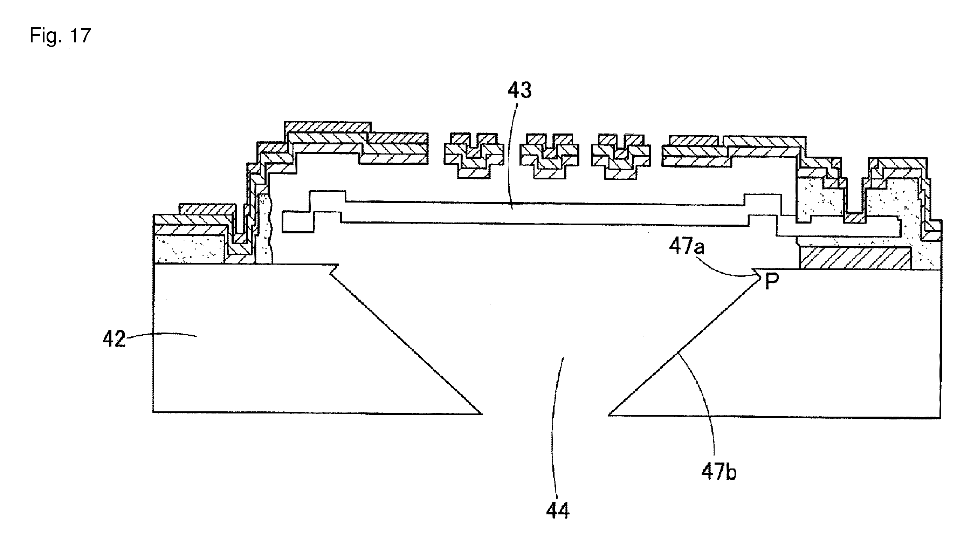

Fig. 17 is a sectional view of an acoustic sensor in a modification example of First Embodiment of the present invention.

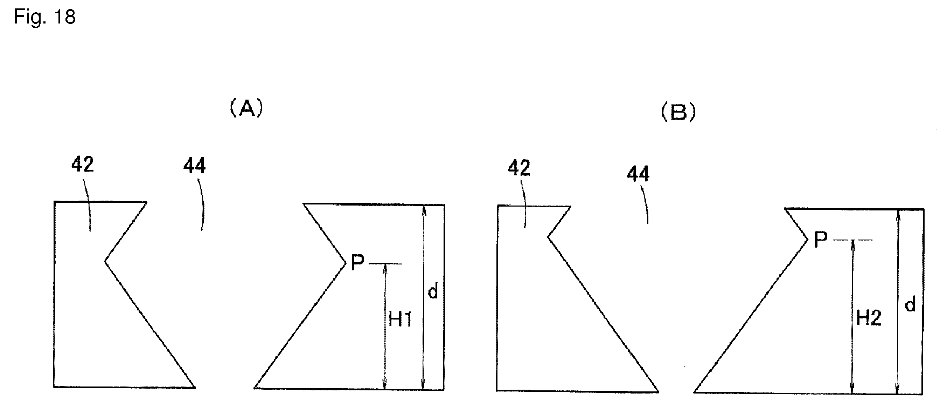

Fig. 18(A) is a schematic view of an X-X cross section of the substrate (Fig. 11) used in another modification example of a first embodiment of the present invention, and Fig. 18(B) is a schematic view of a Y-Y cross section of the substrate (Fig. 11).

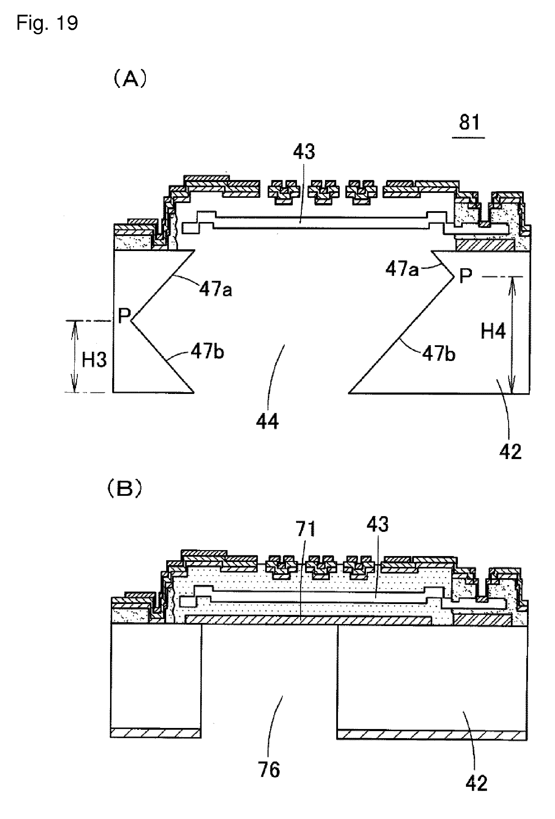

Fig. 19(A) is a sectional view of an acoustic sensor in accordance with a second embodiment of the present invention, and Fig. 19(B) is a schematic view showing a method for manufacturing the acoustic sensor in Fig. 19(A).

DESCRIPTION OF SYMBOLS

41, 81: acoustic sensor
42: substrate
43: diaphragm
44: cavity
44a: front surface opening
44b: back surface opening
46: fixed electrode
47a: first inclined surface
47b: second inclined surface
61: microphone module
62: casing
63: base
64: cover
65: acoustic introduction port
71: sacrifice layer
76: through hole

MODE FOR CARRYING OUT THE INVENTION

Preferred embodiments according to the present invention will be described below with reference to appended drawings. However, the present invention is not limited to the following embodiments, and may be modified in design in various ways so as not to deviate from the subject matter of the present invention.

(Acoustic sensor in a first embodiment)

Fig. 10 is a sectional view showing a configuration of an acoustic sensor 41 in accordance with a first embodiment of the present invention. The acoustic sensor 41 has a substrate 42, a thin-film diaphragm 43, a back plate 45, and a fixed electrode 46. The substrate 42 is a (100) plane Si substrate including a front surface and a back surface as (100) planes. A cavity 44 penetrating the substrate 42 is formed by etching from the back surface. The cavity 44 has wall surfaces in four directions, and as shown in Fig. 11, is rectangular when viewed in a direction perpendicular to the front surface of the substrate 42, and each side is oriented in a (110) direction or a direction equivalent to the (110) direction.

Fig. 10 shows a cross section of the acoustic sensor 41 taken along a line K-K in Fig. 11. Each of the wall surfaces of the cavity 44 is configured of a first inclined surface 47a and a second inclined surface 47b, which are (111) planes or crystal faces equivalent to the (111) planes. Both the inclined surfaces 47a and 47b have an inclination angle $\alpha$ of 54 degrees with respect to the back surface of the substrate 42, and are inclined in different directions. That is, the first inclined surface 47a is inclined between the front surface of the substrate 42 and a middle portion (section P) of the substrate 42 in the thickness direction so as to gradually widen from the front surface of the substrate 42 to the middle portion toward the outside of the substrate 42. The second inclined surface 47b is inclined between the middle portion (section P) and the back surface of the substrate 42 from the middle portion to the back surface of the substrate 42 toward the inside of the substrate 42. Hereinafter, a site at the boundary between the first inclined surface 47a and the second inclined surface 47b, where the inclination direction of the inclined surfaces changes, will be referred to as the section P.

Thus, the cavity 44 is inverted-tapered with the second inclined surface 47b from the back surface of the substrate 42 to the section P in the X-X cross section or the Y-Y cross section of the substrate 42 in Fig. 11. The cavity 44 is tapered with the first inclined surfaces 47a from the section P to the front surface of the substrate 42. As a whole, the cavity 44 is shaped like a barrel that is wider in the middle portion.

In the first embodiment, the sections P of the opposed wall surfaces have a uniform height H (height measured from the back surface of the substrate in the thickness direction). The height H of the section P in the X-X cross section is also equal to the height H of the section P in the Y-Y cross section. Accordingly, in the cavity 44, the area of a cross section parallel to the front surface of the substrate 42 gradually increases from the front surface toward the back surface of the substrate, and stops increasing and starts to decrease gradually from the section P located in the middle of the front surface and the back surface of the substrate. In the first embodiment, the height H of the section P is larger than a half of a thickness d of the substrate 42. That is, since H is larger than d/2, an area of an opening of the cavity 44 in the back surface of the substrate (back surface opening 44b) is smaller than an area of an opening of the cavity 44 in the front surface of the substrate (front surface opening 44a).

As shown in Fig. 10, given that the thickness of the substrate 42 is d, the height of the section P is H, the width of the opening in the front surface of the substrate of the cavity 44 (hereinafter referred to as front surface opening width) is U, and the width of the opening in the front surface of the substrate of the cavity 44 (hereinafter referred to as back surface opening width) is D, since the inclination angle $\alpha$ of the first and second inclined surfaces 47a and 47b is 54 degrees, the back surface opening width D of the cavity 44 is represented by following Formula 1.

$$D = U + 2 \times (d - H)/\tan\alpha - 2 \times H/\tan\alpha$$

$$= U + 2 \times (d - 2 \times H)/\tan\alpha \ldots \text{(Formula 1)}$$

Formula 1 demonstrates that, when the back surface opening width D is smaller than the front surface opening width U (D < U), d/2 is smaller than H. That is, the section P is located above the center of the substrate 42 in the thickness direction. Since the height H of the section P must be located below the front surface of the substrate 42 (H < d), the width of the cavity 44 is represented by following Formula 2.

$$D > U - 2 \times d/\tan\alpha \ldots \text{(Formula 2)}$$

The diaphragm 43 is a substantially rectangular conductive thin film, and legs 48 diagonally extend from four corners of the film. The diaphragm 43 is arranged over the substrate 42 so as to cover the front surface opening 44a of the cavity 44, and each of the legs 48 is fixed to the front surface of the substrate 42 by use of a support table 49.

The stiff back plate 45 is provided over the front surface of the substrate 42 at a distance from the diaphragm 43 so as to cover the diaphragm 43. The fixed electrode 46 made of metal material is provided on the upper surface of the back plate 45. An electrode pad 51 electrically connected to the fixed electrode 46 and an electrode pad 52 electrically connected to the diaphragm 43 are also provided on the back plate 45. A plurality of acoustic holes 50 are formed in the back plate 45 and the fixed electrode 46.

When acoustic vibrations enter into the acoustic sensor 41 from the cavity 44 or from the back plate 45 through the acoustic holes 50, the diaphragm 43 vibrates in response to the acoustic vibrations. The diaphragm 43 is displaced by vibrations to change the distance between the diaphragm 43 and the fixed electrode 46, in turn, to change a capacitance between the diaphragm 43 and the fixed electrode 46. As a result, the acoustic vibrations are converted into an electrical signal, and the electrical signal is outputted from the acoustic sensor 41.

Fig. 12 is a sectional view of a microphone module 61 in which the acoustic sensor 41 is mounted in the casing 62. The casing 62 is configured of a flat plate-like base 63 and a lid-like cover 64 that covers the upper surface of the base 63, and the upper surface of the cover 64 has an acoustic introduction port 65. The acoustic sensor 41 in a vertically inverted state is fixed to the lower surface of the cover 64. The acoustic sensor 41 is mounted such that the cavity 44 communicates with the acoustic introduction port 65, and the cavity 44 serves as a front chamber of the acoustic sensor 41. A space 66 in the casing 62 serves as a back chamber of the acoustic sensor 41.

Since the microphone module 61 using the acoustic sensor 41 has reduced the back surface opening width and the back surface opening area of the cavity 44, it is hard for dirt and dust to enter into the cavity 44 through the back surface opening 44b, preventing dirt and dust from adhering to the diaphragm 13 to change or degrade characteristics of the acoustic sensor 41.

Further, since the area of the back surface of the substrate 42 increases by the reduction in size of the back surface opening of the cavity 44, the mounting surface for the acoustic sensor 41 can be increased. Thus, when the acoustic sensor 41 is die-bonded to the casing 62, fixing strength and stability can be improved. Especially, the inclination of the die-bonded acoustic sensor 41 can be reduced, stabilizing the mounting posture of the acoustic sensor 41

Since the area of the front surface opening of the cavity 44 is substantially equal to the area of the diaphragm 43, the volume of the cavity 44 can be reduced by making the area of the back surface opening of the cavity 44 smaller than the area of the front surface opening. This can improve high frequency characteristics of the acoustic sensor 41. A solid curve in Fig. 13 represents a frequency-sensitivity characteristic of the acoustic sensor 41. A broken curve in Fig. 13 represents a frequency-sensitivity characteristic in the case where the volume of the cavity 44 is large because the area of the back surface opening of the cavity 44 is larger than the area of the front surface opening. By making the area of the back surface opening of the cavity 44 smaller than the area of the front surface opening to reduce the volume of the cavity 44 as described above, as represented by the solid curve in Fig. 14, a resonant portion (peak portion) of the frequency-sensitivity characteristic shifts to the high-frequency side and thus, a flat region of the frequency-sensitivity characteristic extends to the high-frequency side beyond an upper limit of an audible band, thereby achieving a suitable characteristic.

Further, with the acoustic sensor 41, the back surface opening width or the back surface opening area of the cavity 44 can be changed by changing the height H of the section P, to adjust the volume of the cavity 44.

Moreover, with the acoustic sensor 41, as described below, since the cavity 44 can be formed in the substrate 42 by etching from the back surface only, the diaphragm 43 and the back plate 45 require no etching hole. For this reason, there is no possibility that acoustic vibrations having entered into the cavity 44 reach the diaphragm 43 and leak through any etching hole, preventing an acoustic resistance of the acoustic sensor 41 from increasing to lower the sensitivity in the low-frequency region (refer to Fig. 7).

(Method for manufacturing acoustic sensor in a first embodiment)

Next, with reference to Figs. 14 and Figs. 15, a method for manufacturing the acoustic sensor 41 in accordance with the first embodiment of the present invention will be described below. Although a lot of acoustic sensors 41 are manufactured on a wafer at one time, only one acoustic sensor 41 will be described below.

First, by using a general MEMS technique, as shown in Fig. 14(A), a sensor structure is prepared on the front surface of the (100) plane Si substrate 42. That is, a sacrifice layer 71 made of polysilicon, the diaphragm 43, the support table 49 for supporting the legs 48 of the diaphragm 43, a support portion 72 for supporting the lower surface of the outer edge of the back plate 45, protection films 73 and 74 made of $SiO_2$, the back plate 45 made of SiN, and the fixed electrode 46 and the electrode pads 51 and 52, which each are formed of a metal film (for example, a two-layered film including a Cr lower layer and an Au upper layer) are prepared on the front surface of the substrate 42. In the region where the front surface opening 44a of the cavity 44 is to be formed, the sacrifice layer 71 has the substantially same area as the diaphragm 43. The protection films 73 and 74 cover the front surface of the diaphragm 43. A plurality of acoustic holes 50 are formed in the back plate 45 and the fixed electrode 46. The back surface of the substrate 42 is covered with a protection film 75 made of $SiO_2$.

After that, the substrate 42 is dry-etched upwards from the back surface by a method such as DRIE to form a columnar through hole 76 in the substrate 42 as shown in Fig. 14(B). At this time, the sacrifice layer 71 needs to be exposed upwards from the through hole 76 by dry etching. However, since the sacrifice layer 71 may be etched immediately above the through hole 76 by dry etching, it is no need to accurately control the etching depth. The through hole 76 is formed so as to have the substantially same horizontal cross section as the back surface opening 44b of the cavity 44.

Next, an etching liquid such as TMAH is introduced from the back surface of the substrate 42 into the through hole 76. The etching liquid can etch the substrate 42 and the sacrifice layer 71, but cannot etch the protection layers 73 and 75. Thus, the etching liquid having entered into the through hole 76 etches and removes the sacrifice layer 71, spreads along the front surface of the substrate 42, and etches the substrate 42 from the front surface. Accordingly, as shown in Fig. 15(A), the substrate 42 is anisotropically etched around the through hole 76 from the front surface toward the back surface, and at the same time, is anisotropically etched from the inner wall surface of the through hole 76.

As a result, as shown in Fig. 16, the inclined surface 47a passing an end of the sacrifice layer 71 is formed by anisotropic etching from the front surface of the substrate 42, and the inclined surface 47b passing the lower end of the inner wall surface of the through hole 76 is formed by anisotropic etching from the inner wall surface of the through hole 76. In this manner, as shown in Fig. 15(B), a space extending from the through hole 76 forms the barrel-shaped cavity 44.

After that, the protection films 73 and 74 on the side of the front surface and the protection film 75 on the side of the back surface are removed by etching to produce the acoustic sensor 41 as shown in Fig. 10.

According to the above-mentioned manufacturing method, since the barrel-shaped cavity 44 can be formed only by dry etching and wet etching from the back surface of the substrate 42, the sensor structure on the side of the front surface of the substrate 42 does not need to have an etching hole for making the cavity 44. For this reason, the acoustic resistance against acoustic vibrations having entered from the cavity 44 can be increased, suppressing lowering of the sensitivity in the low-frequency region.

As apparent from the above-mentioned manufacturing method, the front surface opening width of the cavity 44 is determined based on the width of the sacrifice layer 71, and the back surface opening width of the cavity 44 is determined based on the width of the through hole 76 formed by dry etching . However, the back surface opening width of the cavity 44 is slightly larger than the width of the through hole 76 due to overetching.

(Modification example of a first embodiment)

The acoustic sensor 41 shown in Fig. 10 has the barrel-shaped cavity 44. By bringing the section P close to the front surface of the substrate 42 as much as possible to reduce a region of the first inclined surface 47a, in contrast, as shown in Fig. 17, the substantially tapered cavity 44 can be formed by etching from only the back surface.

The height of the section P may be varied depending on the direction of the cross section. For example, in the substrate 42 in Fig. 11, given that the height of the section P in the X-X cross section is H1, and the height of the section P in the Y-Y cross section is H2, the heights H1 and H2 of the sections P may be different. Fig. 18(A) shows the X-X cross section of the substrate 42, and Fig. 18(B) shows the Y-Y cross section of the substrate 42. When the height H1 of the section P is smaller than the height H2 of the section P, in the cavity 44 of such shape, an area of the cross section of the cavity 44, which is parallel to the front surface of the substrate 42 (hereinafter referred to as horizontal cross-sectional area) varies from the front surface toward the back surface of the substrate 42 as follows. From the front surface of the substrate 42 to the height H2, in the X-X cross section, the sectional width gradually increases from the front surface toward the back surface, and also in the Y-Y cross section, the sectional width increases from the front surface toward the back surface, and therefore, the horizontal cross-sectional area of the cavity 44 gradually increases with a relatively large increase rate. From the height H2 to the height H1, in the X-X cross section, the sectional width gradually increases from the front surface toward the back surface, but in the Y-Y cross section, the sectional width gradually decreases from the front surface toward the back surface. Accordingly, an increase or decrease in the horizontal cross-sectional area of the cavity 44 is almost zero or small. From the height H1 to the back surface of the substrate 42, in the X-X cross section, the sectional width gradually decreases from the front surface to the back surface, and also in the Y-Y cross section, the sectional width gradually decreases from the front surface to the back surface, and therefore, the horizontal cross-sectional area of the cavity 44 gradually decreases with a relatively large decrease rate.

A means for converting acoustic vibrations into an electrical signal is not limited to the above-mentioned capacitive type using the fixed electrode, and may be a piezoresistance type to detect distortion of the diaphragm.

(Second Embodiment)

Fig. 19(A) is a sectional view of an acoustic sensor 81 in accordance with a second embodiment of the present invention. With the acoustic sensor 81, by making heights H3 and H4 of the sections P of the opposed wall surfaces in the cavity 44 different from each other, the wall surfaces have different sectional shapes. In this case, although the height H4 of one section P is higher than a half of the thickness of the substrate 42, the height H3 of the other section P may be higher or lower than a half of the thickness of the substrate 42.

To form such asymmetrical cavity 44, in the method for manufacturing the acoustic sensor in First Embodiment, when the through hole 76 is formed in the substrate 42 by dry etching, as shown in Fig. 19(B), the center of the through hole 76 is displaced from the horizontal center of the sacrifice layer 71.

The through hole 76 does not need to wholly overlap the sacrifice layer 71 when viewed in the direction perpendicular to the front surface of the substrate 42, and only needs to partially overlap the sacrifice layer 71. However, the opening width or opening area of the through hole 76 needs to be smaller than the width or area of the sacrifice layer 71.

In the case where the cavity 44 has the same sectional shape as shown in Fig. 19(A) in both of the X-X cross section and the Y-Y cross section, when the height H3 is smaller than the height H4, the horizontal cross-sectional area of the cavity 44 varies from the front surface toward the back surface of the substrate 42 as follows. From the front surface of the substrate 42 to the height H4, the horizontal cross-sectional area of the cavity 44 gradually increases with a relatively large increase rate. From the height H4 to the height H3, an increase or decrease in the horizontal cross-sectional area of the cavity 44 is almost zero or small. From the height H3 to the back surface of the substrate 42, the horizontal cross-sectional area of the cavity 44 gradually decreases with a relatively large decrease rate.

The heights of the sections P of the opposed wall surfaces may be different from each other in both of the X-X cross section and the Y-Y cross section as shown in Fig. 19(A), and further, the heights of the sections P in the X-X cross section and the Y-Y cross section may be different from each other, resulting in that the cavity 44 has four sections P of different heights.

**Claims**

1. An acoustic sensor comprising:

   a substrate having a cavity penetrating from a front surface to a back surface;
   a thin-film diaphragm arranged adjacent to the front surface of the substrate to cover the cavity; and
   a conversion unit configured to convert acoustic vibrations into an electrical signal on the basis of displacement of the diaphragm, wherein
   the cavity has a plurality of wall surfaces,
   at least one wall surface of the plurality of wall surfaces is configured of a first inclined surface and a second inclined surface, wherein:

   the first inclined surface is between the front surface of the substrate and a middle portion in a thickness direction of the substrate, and gradually widening toward the outside of the substrate as the first inclined surface goes from the front surface of the substrate toward the middle portion, and
   the second inclined surface is between the middle portion and the back surface of the substrate, and narrowing toward the inside of the substrate as the second inclined surface goes from the middle portion to the back surface of the substrate, and wherein in a cross section perpendicular to the wall surface configured of the first inclined surface and the second inclined surface, an opening width of the cavity in the back surface of the substrate is smaller than an opening width of the cavity in the front surface of the substrate.

2. The acoustic sensor according to claim 1, wherein at least one pair of wall surfaces facing each other of the wall surfaces each are configured of the first inclined surface and the second inclined surface, and in at least one pair of wall surfaces facing each other of the wall surfaces, each configured of the first inclined surface and the second inclined surface, the opposed wall surfaces have different heights from the back surface of the substrate to the boundary between the first inclined surface and the second inclined surface.

3. The acoustic sensor according to claim 1, wherein given that a thickness of the substrate is d, an inclination angle of the first and second inclined surfaces is $\alpha$, and in a cross section perpendicular to the wall surface configured of the first and second inclined surfaces, an opening width of the cavity in the front surface of the substrate and an opening width of the cavity in the back surface of the substrate are U and D respectively, a following condition:

$$D > U - 2 \times d/\tan\alpha$$

is satisfied.

4. The acoustic sensor according to claim 1, wherein in the cavity,
in a region near an opening in the front surface of the substrate, an area of a cross section parallel to the front surface of the substrate gradually increases from the front surface of the substrate toward the back surface, and
in a region near an opening in the back surface of the substrate, an area of a cross section parallel to the front surface of the substrate gradually decreases from the front surface of the substrate toward the back surface.

5. The acoustic sensor according to claim 4, wherein the area of the cross section parallel to the front surface of the substrate of the cavity gradually increases from the front surface of the substrate toward the back surface, and then stops increasing and decreases from the middle of the front surface and the back surface of the substrate.

6. The acoustic sensor according to claim 4, wherein the area of the cross section parallel to the front surface of the substrate of the cavity gradually increases from the front surface of the substrate toward the back surface with a relatively large increase rate, and gradually decreases with a relatively large decrease rate when an increase or decrease in the area of the cross section becomes small.

7. The acoustic sensor according to claim 5 or 6, wherein
in the cavity, a thickness of a region where the area of the cross section parallel to the front surface of the substrate increases from the front surface of the substrate toward the back surface is smaller than a thickness of a region where the area of the cross section parallel to the front surface of the substrate decreases from the front surface of the substrate toward the back surface.

8. The acoustic sensor according to claim 1, wherein the diaphragm is made of a conductive material, and the conversion unit is a fixed electrode arranged parallel to the diaphragm on the side of the front surface of the substrate.

9. A method for manufacturing the acoustic sensor according to claim 1, the method comprising steps of:

preparing a sacrifice layer on the front surface of the substrate;
preparing the thin-film diaphragm above the sacrifice layer;
preparing the conversion unit configured to convert acoustic vibrations into an electrical signal based on displacement of the diaphragm;
forming a through hole on the substrate, the through hole having a smaller opening width in a direction parallel to the back surface of the substrate than a width of the sacrifice layer, by dry etching the substrate from the back surface of the substrate to cause the hole to penetrate the substrate from the back surface to the front surface along the thickness direction of the substrate; and
forming the cavity in the substrate by anisotropically etching the substrate from the front surface of the substrate while removing the sacrifice layer through etching; and
anisotropically etching the substrate from an inner wall surface of the through hole by introducing an etching liquid into the through hole.

10. The acoustic sensor manufacturing method according to claim 9, wherein
the sacrifice layer is formed in a region corresponding to a front surface opening of the cavity, and
the opening of the through hole in the back surface of the substrate is formed in a region corresponding to a back surface opening of the cavity.

11. The acoustic sensor manufacturing method according to claim 9, wherein
in the step of forming the through hole, the center of the through hole is displaced from the horizontal center of the sacrifice layer in a horizontal direction to form the through hole.

12. The acoustic sensor manufacturing method according to claim 11, wherein
at least a part of the through hole overlaps the sacrifice layer when viewed in a direction perpendicular to the front surface of the substrate.

Fig. 1

(A)

(B)

(C)

Fig. 2

Fig. 3

Fig. 4

(A)

(B)

Fig. 5

Fig. 6

Fig. 7

Sensitivity (output)

Frequency

Audible band

EP 2 753 099 A1

Fig. 8

## Fig. 9

(A)

(B)

(C)

(D)

Fig. 10

EP 2 753 099 A1

Fig. 11

Fig. 12

EP 2 753 099 A1

Fig. 13

Fig. 14

(A)

(B)

Fig. 15

(A)

(B)

Fig. 16

Fig. 17

EP 2 753 099 A1

Fig. 18

(A)                                    (B)

Fig. 19

(A)

(B)

## INTERNATIONAL SEARCH REPORT

International application No.

PCT/JP2012/071800

### A. CLASSIFICATION OF SUBJECT MATTER
*H04R19/04*(2006.01)i, *H01L29/84*(2006.01)i, *H04R31/00*(2006.01)i

According to International Patent Classification (IPC) or to both national classification and IPC

### B. FIELDS SEARCHED

Minimum documentation searched (classification system followed by classification symbols)
H04R19/04, H01L29/84, H04R31/00

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>A | JP 2008-271568 A (Omron Corp.),<br>06 November 2008 (06.11.2008),<br>paragraphs [0006], [0009], [0030], [0032],<br>[0070] to [0081]; fig. 5, 17, 19 to 21<br>(Family: none) | 1,3-5,7-8<br>2,6,9-12 |

☐ Further documents are listed in the continuation of Box C.     ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
|---|---|
| Date of the actual completion of the international search<br>01 October, 2012 (01.10.12) | Date of mailing of the international search report<br>09 October, 2012 (09.10.12) |
| Name and mailing address of the ISA/<br>Japanese Patent Office | Authorized officer |
| Facsimile No. | Telephone No. |

Form PCT/ISA/210 (second sheet) (July 2009)

**REFERENCES CITED IN THE DESCRIPTION**

**Patent documents cited in the description**

- JP 4273438 B
- US 7514287 B
- JP 4539450 B
- JP 2007295487 A